# EUROPÄISCHE PATENTANMELDUNG

(11) **EP 1 111 682 A2**
(43) Veröffentlichungstag der Anmeldung: **27.06.2001**
(21) Anmeldenummer: 00126788.9
(22) Anmeldetag: 06.12.2000
(51) Int. Cl.: H01L 27/108, H01L 21/8242

(54) **DRAM-Zelle mit zwei MOS-Transistoren**

(30) Priorität: 21.12.1999 DE 19961779
(71) Anmelder: Infineon Technologies AG, 81669 München (DE)
(72) Erfinder: Hofmann, Franz, 80995 München (DE); Krautschneider, Wolfgang, 21149 Hamburg (DE); Schlösser, Till, 81825 München (DE)
(74) Vertreter: MÜLLER & HOFFMANN Patentanwälte

(57) **Zusammenfassung**

Integrierte dynamische Speicherzelle (1) mit geringer Ausbreitungsfläche auf einem Halbleitersubstrat, die einen Auswahl-MOSFET (2) mit einem Gatenanschluss-Bereich (8, 33), der mit einer Wortleitung WL verbunden ist, einem Sourceanschluss-Dotierungsbereich (9, 26), der mit einer Bitleitung BL verbunden ist, und mit einem Drainanschluss-Dotierungsbereich (11, 27) und einen Speicher-MOSFET (3) mit einem Gateanschluss-Bereich (15, 32), der über eine dünne dielektrische Schicht (35) an ein Verbindungs-Dotierungsgebiet (12, 27) angeschlossen ist, welches einen Sourceanschluss-Dotierungsbereich (13) des Speicher-MOSFETs (3) mit dem Drainanschluss-Dotierungsbereich (11) des Auswahl-MOSFETs (2) verbindet, und mit einem Drainanschluss-Dotierungsbereich (14, 24), der an eine Versorgungsspannung VDD anliegt, aufweist, wobei der Auswahl-MOSFET (2) und der Speicher-MOSFET (3) in einem in das Halbleitersubstrat geätzten Graben (21) an den Seitenwänden (28, 29) des Grabens (21) derart angeordnet sind, dass sie einander gegenüberliegen und das Verbindungs-Dotierungsgebiet (27) den Boden des geätzten Grabens (21) bildet.

## Beschreibung

Die Erfindung betrifft eine integrierte dynamische Speicherzelle mit geringer Ausbreitungsfläche, die in einem in das Substrat geätzten Graben integriert ist.

Ein dynamischer Halbleiterspeicher besteht aus einer Vielzahl von Speicherzellen. Eine herkömmliche Speicherzelle weist eine Speicherkapazität auf, die über einen Auswahltransistor an die Bitleitung BL angeschlossen werden kann. Wird eine Wortleitung WL auf einen hohen Spannungspegel gelegt, so öffnet der Auswahltransistor, und die Speicherkapazität wird an die Bitleitung BL geschaltet. In diesem Zustand kann ein Datum in die Speicherzelle eingeschrieben werden, indem die Kapazität auf den gewünschten Speicherinhalt entladen oder aufgeladen wird.

Um dynamische Speicher mit einer Speicherkapazität im Gigabitbereich zu erreichen, müssen sehr viele Speicherzellen auf der Substratchipfläche integriert werden. Da die Substratchipfläche begrenzt ist, ist es notwendig, die Ausbreitungsfläche einer einzelnen integrierten dynamischen Speicherzelle möglichst gering zu halten. Die Miniaturisierung wird dabei auch durch die angewandte Lithographietechnik bestimmt. Durch die angewandte Lithographietechnik wird eine minimale lithographische Strukturgröße F bestimmt, die derzeit bei etwa 150 bis 200 nm liegt.

Ein Nachteil der herkömmlichen Speicherzelle besteht darin, dass bei einer zunehmenden Integration zu kleineren Strukturen die Kapazität des Speicherkondensators nicht verkleinert werden kann. Es wurde daher in der EP 0537203 B1 die in Figur 8 gezeigte Speicherzelle mit zwei MOSFET-Transistoren vorgeschlagen. Jedoch ist die Ausbreitungsfläche bei der dort beschriebenen Speicherzelle relativ groß, da die Speicherzelle planar auf der Substratoberfläche ausgebildet wird.

Es ist daher die Aufgabe der vorliegenden Erfindung, eine integrierte dynamische Speicherzelle und deren Herstellungsverfahren zu schaffen, bei der die Ausbreitungsfläche auf der Chipsubstratoberfläche minimal ist.

Diese Aufgabe wird erfindungsgemäß durch eine integrierte dynamische Speicherzelle mit den im Patentanspruch 1 angegebenen Merkmalen sowie durch ein Herstellungsverfahren mit den im Patentanspruch 19 angegebenen Merkmalen gelöst.

Die Erfindung schafft eine integrierte dynamische Speicherzelle mit geringer Ausbreitungsfläche, die einen Auswahl-MOSFET mit einem Gateanschluss-Bereich, der mit einer Wortleitung verbunden ist, einem Sourceanschluss-Dotierungsbereich, der mit einer Bitleitung verbunden ist, und mit einem Drainanschluss-Dotierungsbereich,
und einen Speicher-MOSFET aufweist mit einem Gateanschluss-Bereich, der über eine dünne dielektrische Schicht an ein Verbindungs-Dotierungsgebiet angeschlossen ist, welches einen Sourceanschluss-Dotierungsbereich des Speicher-MOSFETs mit dem Drainanschluss-Dotierungsbereich des Auswahl-MOSFETs verbindet, und mit einem Drainanschluss-Dotierungsbereich, der an eine Versorgungsspannung anliegt,
wobei der Auswahl-MOSFET und der Speicher-MOSFET in einem in das Halbleitersubstrat geätzten Graben an den Seitenwänden des Grabens derart angeordnet sind, dass sie einander gegenüberliegen und das Verbindungs-Dotierungsgebiet den Boden des geätzten Grabens bildet.

Bei einer bevorzugten Ausführungsform der erfindungsgemäßen dynamischen Speicherzelle ist der Auswahl-MOSFET und der Speicher-MOSFET jeweils ein NMOS-Transistor.

Bei einer weiteren bevorzugten Ausführungsform der erfindungsgemäßen Speicherzelle weist die dünne dielektrische Schicht eine Dicke von unter 2 nm auf, so dass die dünne dielektrische Schicht für Tunnelströme durchlässig ist.

Bei einer weiteren bevorzugten Ausführungsform sind die durch die dünne dielektrische Schicht fließenden Tunnelströme durch die Dotierung des Gateanschluss-Bereichs und des Verbindungs-Dotierungsgebietes einstellbar.

Die dünne dielektrische Schicht weist vorzugsweise eine asymmetrische Stromdurchlasskennlinie ähnlich einer Diode auf.

Vorzugsweise besteht die dünne dielektrische Schicht aus einem Oxid, Nitrid oder Oxynitrid.

Bei einer weiteren bevorzugten Ausführungsform der erfindungsgemäßen dynamischen Speicherzelle weisen der Auswahl-MOSFET und der Speicher-MOSFET jeweils eine Gateoxidschicht auf, die entlang den Seitenwänden des geätzten Grabens verlaufen.

Bei einer weiteren Ausführungsform der erfindungsgemäßen dynamischen Speicherzelle werden die Gateanschluss-Bereiche des Auswahl-MOSFETs und des Speicher-MOSFETs durch Spacer gebildet.

Bei einer bevorzugten Ausführungsform werden die Sourceanschluss-Bereiche und die Drainanschluss-Bereiche der beiden MOSFETS und das Verbindungs-Dotierungsgebiet durch Ionenimplantation dotiert.

Bei einer weiteren bevorzugten Ausführungsform der erfindungsgemäßen dynamischen Speicherzelle liegen neben den GateOxidschichten des Auswahl-MOSFETs und des Speicher-MOSFETs jeweils dotierte Stromleitkanäle, deren Dotierung zur Festlegung der jeweiligen Einsatzspannung der beiden MOSFETS einstellbar ist.

Die dotierten Stromleitkanäle werden vorzugsweise durch Ionenimplantation dotiert.

Die Breite des geätzten Grabens entspricht bei einer besonders bevorzugten Ausführungsform der erfindungsgemäßen dynamischen Speicherzelle der minimalen lithographischen Strukturgröße.

Die Länge der dotierten Stromleitkanäle entspricht dabei vorzugsweise im wesentlichen der Tiefe des geätzten Grabens.

Bei einer weiteren Ausführungsform der erfindungsgemäßen dynamischen Speicherzelle ist die Tiefe des geätzten Grabens größer als die Breite des geätzten Grabens.

Vorzugsweise wird der Gateanschluss-Bereich des Auswahl-MOSFETs einer dynamischen Speicherzelle durch eine im geätzten Graben durchgängig verlaufenden Spacer gebildet, der den Gateanschluss-Bereich für eine Vielzahl von weiteren Auswahl-MOSFETS von anderen dynamischen Speicherzellen bildet.

Bei einer weiteren Ausführungsform der erfindungsgemäßen Speicherzelle beträgt die Ausbreitungsfläche der dynamischen Speicherzelle etwa das Vierfache der quadratischen lithographischen Strukturgröße.

Die Halbleitersubstratbereiche von Auswahl-MOSFETS verschiedener Speicherzellen, die auf einer Seitenwand des geätzten Grabens angeordnet sind, werden vorzugsweise durch Isolierschichten voneinander getrennt angeordnet.

Bei einer weiteren bevorzugten Ausführungsform der erfindungsgemäßen dynamischen Speicherzelle sind die Halbleitersubstratbereiche von Speicher-MOSFETS, die auf einer gegenüberliegenden Seite des geätzten Grabens angeordnet sind, ebenfalls durch Isolierschichten voneinander getrennt.

Die Erfindung schafft ferner ein Verfahren zur Herstellung einer integrierten dynamischen Speicherzelle mit den folgenden Schritten, nämlich
Implantieren der Oberfläche eines Halbleitersubstrats,
Ätzen eines Grabens in das Halbleitersubstrat,
Implantieren des Halbleitersubstrats am Boden des geätzten Grabens,
thermisches Oxidieren der beiden Seitenwände des geätzten Grabens zur Ausbildung von dielektrischen Schichten an den Seitenwänden,
Abscheiden einer isolierenden Oxidschicht auf dem Boden des geätzten Grabens,
Ausbilden von Polysilizium-Spacern an den Seitenwänden des geätzten Grabens,
Ätzen der isolierenden Oxidschicht mit den gebildeten Polysilizium-Spacern als Maskierung, wobei ein mittlerer Oberflächenbereich des implantierten Halbleitersubstrats am Grabenboden freigelegt wird,
Füllen einer Hälfte des geätzten Grabens mit einem isolierenden Material,
Abscheiden einer dünnen dielektrischen Schicht auf der verbliebenen Hälfte des mittleren Oberflächenbereichs des Halbleitersubstrats am Boden des geätzten Grabens,
Abscheiden einer Polysiliziumschicht auf der dünnen dielektrischen Schicht.

Das erfindungsgemäße Verfahren schafft eine selbstverstärkende dynamische Speicherzelle , die nur einen sehr geringen Flächenbedarf hat. Der Herstellungsprozess ist dabei besonders einfach, da die gebildeten Masken streifenförmig sind, wodurch die Photolithographie stark vereinfacht wird. Da der geätzte Graben zur Aufnahme der MOSFETS in die Speicherzelle relativ tief sein kann, sind auch die Stromleitkanäle der MOSFETS relativ lang, so dass Leckströme, die über den Auswahltransistor abfließen können, besonders gering sind. Die asymmetrische Stromdurchlasskennlinie aufgrund der Tunnelströme durch die dünne dielektrische Schicht können durch die Dotierung der anliegenden dotierten Schichten eingestellt werden. Hierdurch kann das dynamische Verhalten der Speicherzelle entsprechend der gewünschten Anwendung beeinflusst werden.

Im weiteren werden bevorzugte Ausführungsformen der integrierten dynamischen Speicherzelle und das Verfahren zu deren Herstellung unter Bezugnahme auf die beigefügten Figuren zur Erläuterung erfindungswesentlicher Merkmale beschrieben.

Es zeigen:
- Fig. 1-5: mehrere Herstellungsschritte zur Herstellung der erfindungsgemäß integrierten dynamischen Speicherzelle;
- Fig. 6, 7: die Herstellungsschritte für eine alternative Ausführungsform der erfindungsgemäßen dynamischen Speicherzelle;
- Fig. 8: ein Schaltkreisdiagramm der erfindungsgemäßen integrierten dynamischen Speicherzelle.

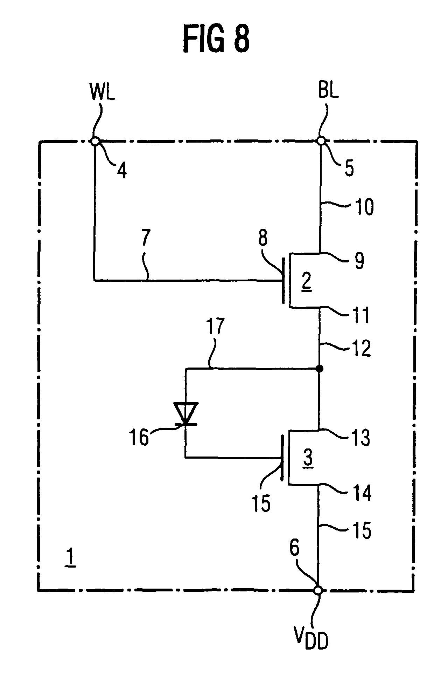

Wie man aus Fig. 8 erkennen kann, besteht die erfindungsgemäße integrierte dynamische Speicherzelle 1 im wesentlichen aus zwei MOSFET-Transistoren 2, 3. Die MOSFET-Transistoren 2, 3 sind vorzugsweise NMOS-MOSFETS. Die Speicherzelle 1 weist einen ersten Anschluss 4 zum Anschluss an eine Wortleitung WL , einen zweiten Anschluss 5 zum Anschluss an eine Bitleitung BL und einen dritten Anschluss 6 zum Anschluss an eine Versorgungsspannung V_{DD} des Speichers auf. Die Wortleitung 4 ist über eine Leitung 7 mit dem Gate 8 des MOSFETs 2 verbunden. Der Sourceanschluss 9 des MOSFETs 2 ist über eine Leitung 10 mit dem Bitleitungsanschluss 5 verbunden. Der Drainanschluss 11 des MOSFETs 2 ist über eine Verbindungsleitung 12 an den Sourceanschluss 13 des MOSFETs 3 angeschlossen. Der Drainanschluss 14 des MOSFETs 3 liegt über eine Leitung 15 an dem Versorgungsspannungsanschluss 6 an. Das Gate 15 ist über ein als Diode dargestelltes Bauelement 16 und eine Stromleitung 17 an die Verbindungsleitung 12 der beiden MOSFETS 2, 3 gekoppelt. Das Bauelement 16 verhält sich ähnlich einer Diode bzw. einem asymmetrischen Widerstand und weist eine asymmetrische Stromdurchlasskennlinie auf.

Die Funktionsweise der in Fig. 8 dargestellten erfindungsgemäßen Speicherzelle ist wie folgt.

In die Speicherzelle 1 kann eine Ladung eingeschrieben und abgespeichert werden. Der MOSFET 2 bildet den Auswahl-MOSFET der Speicherzelle 1, und der MOSFET 3 bildet den Speicher-MOSFET der Speicherzelle 1.

Zum Einschreiben bzw. Abspeichern einer Ladung in den Speicher-MOSFET 3 werden der Bitleitungsanschluss 5 und der Wortleitungsanschluss 4 beide auf einen logisch hohen Spannungspegel gebracht. Der Auswahl-MOSFET 2 wird gesteuert durch seinen Gateanschluss 8 durchgeschaltet, und der logisch hohe Spannungspegel liegt dann an der Verbindungsleitung 12 zwischen den beiden MOSFETS 2, 3 an. Über das diodenähnliche Bauelement 16 wird in einer relativ kurzen Aufladezeit das Gate 15 des Speicher-MOSFETs 3 aufgeladen. Das Gate 15 des Speicher-MOSFETs 3 dient zur Speicherung der eingeschriebenen Ladung und somit der Daten. Das diodenähnliche Bauelement 16 weist eine asymmetrische Stromdurchlasskennlinie auf. Das diodenähnliche Bauelement 16 sorgt für ein gegenüber dem Aufladevorgang verlangsamtes Entladen der auf dem Gate 15 befindlichen Ladung und gewährleistet , dass der Speichertransistor 3 beim Auslesen einer logischen "1" für eine vorbestimmte Zeit geöffnet ist.

Beim Auslesen der abgespeicherten Ladung wird der Bitleitungsanschluss 5 an einen logisch niedrigen Spannungspegel angelegt und der Wortleitungsanschluss 4 zum Öffnen des Auswahl-MOSFETs 2 auf einen logisch hohen Spannungspegel gebracht. Der Auswahl-MOSFET 2 schaltet durch und zieht die Verbindungsleitung 12 auf den an dem Bitleitungsanschluss 5 anliegenden, niedrigen logischen Spannungspegel. Das Gate 15 entlädt sich zeitverzögert über das diodenähnliche Bauelement 16. Dabei fließt zusätzlich, solange sich genug Gate-Ladung auf dem Gate 15 des Speicher-MOSFETs befindet, ein relativ hoher Strom von dem Versorgungsspannungsanschluss 6 über die Leitungen 15, 12, 10 hin zu dem Bitleitungsanschluss 5, da beide MOSFETS 2, 3 durchgeschaltet sind. Dies stellt eine Ladungsverstärkung der in der Speicherzelle 1 abgespeicherten Ladung dar. Die erfindungsgemäße, integrierte dynamische Speicherzelle zeichnet sich also durch die Eigenschaft aus, dass die in die Speicherzelle 1 eingeschriebene Ladung geringer ist als die Ladung, die man beim Auslesen aus der Speicherzelle 1 erhält. Die erfindungsgemäße dynamische Speicherzelle ist somit selbstverstärkend.

Im weiteren wird das erfindungsgemäße Verfahren zur Herstellung der in Fig. 8 als Schaltkreisdiagramm dargestellten, erfindungsgemäßen integrierten dynamischen Speicherzelle 1 beschrieben.

Zunächst wird auf einem Halbleitersubstrat, bei dem es sich vorzugsweise um ein Siliziumsubstrat handelt, eine strukturierte Ätz-Hartmaske mit einer TEOS-Abscheidung aufgebracht. Die Hartmaske besteht dabei aus einer Vielzahl von Streifen, deren Abstand und Breite etwa der minimalen lithographischen Strukturgröße F entspricht. Die minimale lithographische Strukturgröße F liegt bei etwa 0,1 bis 0,2 µm. In einem anschließenden Trockenätzvorgang werden Isoliergräben in das Halbleitersubstrat geätzt, wobei die Isoliergräben dazu dienen, die verschiedenen erfindungsgemäßen dynamischen Speicherzellen auf dem Halbleiterchip voneinander elektrisch zu isolieren. Die Isoliergräben werden mit einem isolierenden Material, beispielsweise einem Oxid gefüllt. Die Isoliergräben sind so tief, dass eine wirksame elektrische Isolierung der Vielzahl von dynamischen Speicherzellen gewährleistet ist. Das Auffüllen der Isoliergräben mit Oxid erfolgt vorzugsweise in einem CVD-Prozess. Anschließend wird die Oberfläche planarisiert.

In einem weiteren Prozessschritt erfolgt eine n-Ionenimplantation zur Dotierung der Oberfläche des Halbleitersubstrats. Dabei werden die Ionen derart beschleunigt, dass sie bis in eine bestimmte Tiefe des Halbleitersubstrats eindringen. Nach der Ionenimplantation wird eine n-Polysiliziumschicht abgeschieden und mittels einer Photolackmaskierung strukturiert derart geätzt, dass Polysiliziumstreifen senkrecht zu den eingebrachten, mit Oxid gefüllten Isoliergräben verlaufen. Der Abstand und die Breite der Polysiliziumstreifen entspricht dabei vorzugsweise ebenfalls der minimalen lithographischen Strukturgröße F. Die gesamte Struktur wird anschließend mit einer strukturierten Siliziumnitrid-Hartmaske zur Grabenätzung überzogen. In einem Trockenätzvorgang wird das Siliziumsubstrat und die darin streifenförmig parallel verlaufenden, mit Oxid gefüllten Isoliergräben zur Ausbildung eines Aufnahmegrabens für die auszubildenden MOSFET-Transistoren der dynamischen Speicherzelle geätzt.

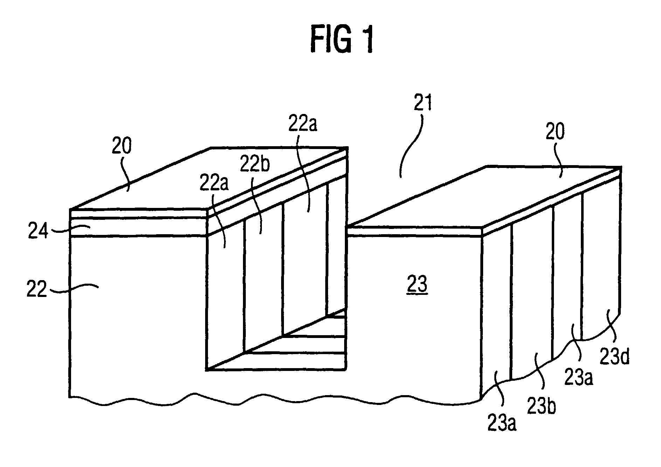

In Fig. 1 erkennt man eine Struktur, die nach Ausführung der oben genannten Prozessschritte entsteht. Auf dem Halbleitersubstrat befindet sich eine Nitrid-Hartmaske 20, wobei in das Halbleitersubstrat ein tiefer Aufnahmegraben 21 geätzt ist. Dadurch entstehen Halbleitersubstratstege 22, 23. Auf dem linken Halbleitersubstratsteg 22 befindet sich eine Schicht 24 aus n-dotiertem Polysilizium. In den beiden Halbleitersubstratstegen 22, 23 wechseln sich jeweils Bereiche 22a, 23a aus reinem Siliziumsubstrat und Bereiche 22b, 23b aus isolierendem Oxid ab.

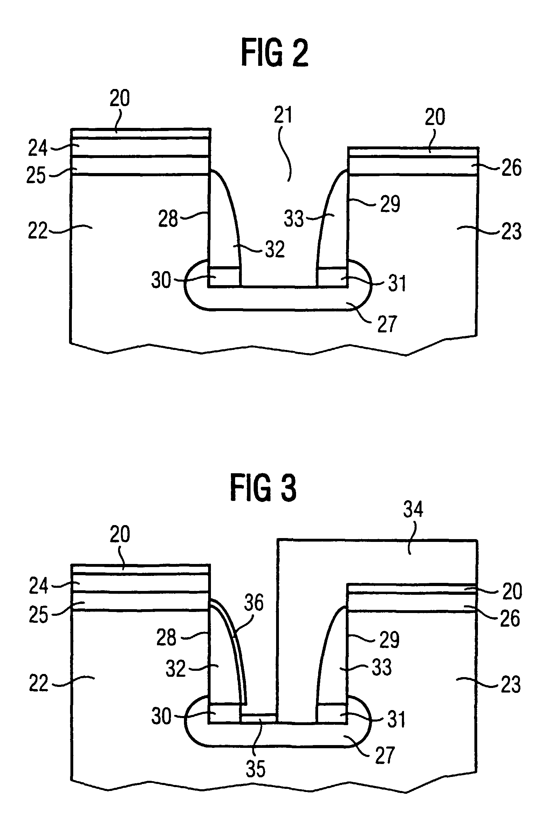

In einem weiteren Schritt werden n-Ionen zur Dotierung des Halbleitersubstrats am Boden des geätzten Grabens 21 implantiert. Daraufhin wird der Ätzgraben 21 mit Siliziumdioxid in einem TEOS-Prozess gefüllt und nach einer Planarisierung, beispielsweise durch einen chemisch-mechanischen CMP-Prozess, wird das in den Ätzgraben 21 gefüllte Siliziumdioxid derart zurückgeätzt, dass am Grabenboden eine isolierende Oxidschicht verbleibt. Die Rückätzung erfolgt in einem Trockenätzvorgang selektiv derart, dass das Siliziumnitrid der Hartmaske 20 nicht angegriffen wird. Mit einer schrägen Implantation von Dotierungsionen werden die Seitenwände des nunmehr weitgehend wieder freigelegten Ätzgrabens 21 zur Bildung von Stromleitkanälen des späteren MOSFETs dotiert. Durch die Stärke der Dotierung wird die Einsatzspannung der späteren MOSFETS eingestellt. Dabei kann die Implantierung der beiden gegenüberliegenden Seitenwände des Ätzgrabens 21 unterschiedlich sein, so dass die Einsatzspannung der beiden MOSFETS 2, 3 der Speicherzelle 1 unterschiedlich einstellbar ist. Nach der Implantation werden die beiden gegenüberliegenden Seitenwände des geätzten Grabens thermisch oxidiert, so dass sich dort eine dielektrische Oxidschicht ausbildet. Diese dielektrische Oxidschicht bildet später die Gateoxidschicht für die MOSFETS 2, 3. Nach der Bildung des Gateoxids werden n⁺-Polysilizium-Spacer durch Polysiliziumabscheidung von Polysilizium in den Ätzgraben 21 und anschließende streng anisotrope Rückätzung des abgeschiedenen Polysiliziums gebildet. Diese Polysilizium-Spacer werden dann als Maskierung zur Strukturierung der am Grabenboden liegenden isolierenden Oxidschicht verwendet. Die am Grabenboden befindliche isolierende Oxidschicht wird selektiv geätzt, so dass die in Fig. 2 dargestellte Struktur entsteht.

Die Fig. 2 ist eine Schnittansicht durch einen Siliziumhalbleiter-Substratbereich 22 nach Durchführung der oben beschriebenen Prozessschritte. Man erkennt die Nitrid-Hartmaskenschicht 20, unter der sich am linken Steg 22 die Schicht 24 aus n-Polysilizium befindet. Dann folgen auf beiden Seiten Schichten 25, 26, die durch die n-Ionenimplantation entstanden sind. Am Boden des geätzten Grabens 21 befindet sich ebenfalls ein n-dotiertes Gebiet 27, das durch n-Ionenimplantation entstanden ist. Auf dem Boden des geätzten Grabens 21 liegt über dem n-dotierten Gebiet 27 die strukturierte isolierende Oxidschicht. Die strukturierte isolierende Oxidschicht besteht aus zwei parallel zu den Seitenwänden 28, 29 verlaufenden Oxidstreifen 30, 31. Die Mitte des Bodens des geätzten Grabens 21 liegt, wie man aus Fig. 2 erkennen kann, frei. Über den beiden Oxidstreifen 30, 31 sind die beiden Spacer 32, 33 aus n-Polysilizium angeordnet. An den Seitenwänden 28, 29 des geätzten Grabens 21 befinden sich jeweils Gateoxidschichten.

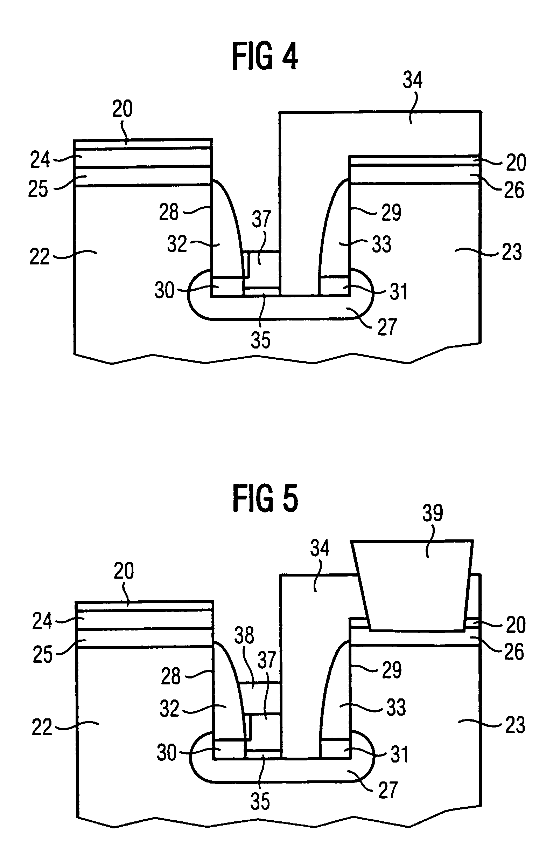

Der geätzte Graben 21 wird nun erneut mit Siliziumdioxid in einem TEOS-Prozess gefüllt und in einem Photoprozess derart strukturiert, dass nur der halbe Graben mit Siliziumdioxid gefüllt bleibt. In einem thermischen Prozess wird eine dünne dielektrische Schicht auf der verbliebenen freiliegenden Hälfte des hinteren Oberflächenbereichs des Substrats am Boden des geätzten Grabens 21 abgeschieden. Die dünne dielektrische Schicht besteht dabei vorzugsweise aus einer NO-Verbindung. Bei dieser Oxid-Nitridation wird der in Fig. 2 gezeigte linke Spacer 32 ebenfalls mit der Oxid-Nitridverbindung bedeckt. Es entsteht die in Fig. 3 dargestellte Struktur. Man erkennt aus Fig. 3, dass die rechte Seite des geätzten Grabens 21 zur Hälfte mit einem isolierenden Material 34 gefüllt ist. Das isolierende Material 34 besteht dabei beispielsweise aus Siliziumdioxid. Zwischen der Oxidschicht 30 und dem isolierenden Füllmaterial 34 befindet sich am Boden des geätzten Grabens 21 die dünne dielektrische Schicht 35, die vorzugsweise aus einer Stickstoff-Sauerstoffverbindung besteht. Ferner ist der linke Spacer 32 mit einer Schicht 36 aus einer Stickstoff-Sauerstoffverbindung überzogen. Die linke Seite des in Fig. 3 gezeigten geätzten Grabens 21 wird anschließend mit n-Polysilizium gefüllt und dieses Polysilizium so weit zurückgeätzt, dass ein Poly-Plug 37 stehen bleibt, wie man aus Fig. 4 erkennen kann. Durch nasschemische Ätzung wird die dünne Schicht 36, die aus einer Stickstoff-Sauerstoffverbindung besteht, auf dem freiliegenden Spacer 32 entfernt, und durch eine weitere Abscheidung von Polysilizium mit anschließender Rückätzung wird der Spacer 31 über eine Schicht 38 aus n-Polysilizium mit dem Polysilizium-Plug 37 verbunden. Nach einem weiteren Photoprozess werden nun der Spacer 32 und der Plug 37, 38 derart strukturiert, dass sie nur in den Siliziumsubstratbereichen 25 stehen bleiben und in den Bereichen 26, die aus Isolieroxid bestehen, entfernt werden.

Anschließend wird die gesamte Struktur mit einem Zwischenoxid gefüllt und mit einer Metallisierung versehen. Dabei wird der Dotierungsbereich 26 auf dem rechten Steg 23 mit einem Bitleitungsmetallkontakt 39 versehen.

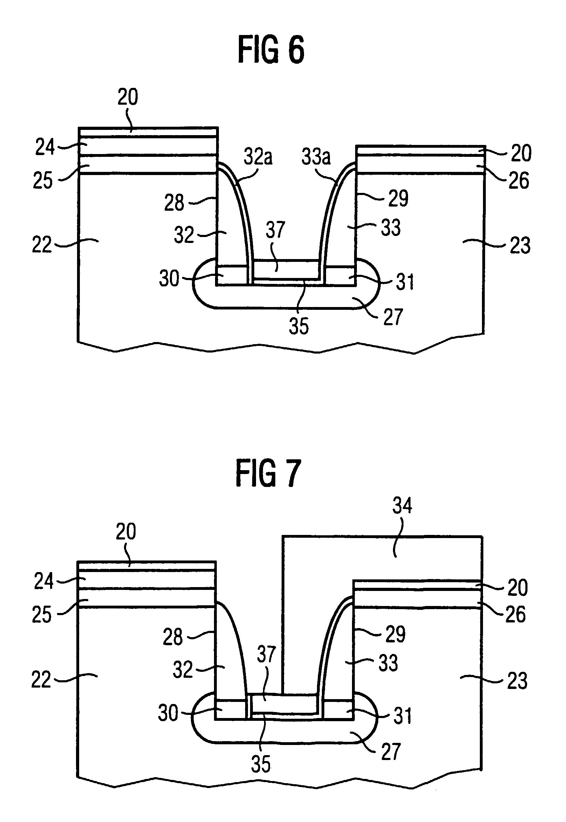

Fig. 5 zeigt eine erste Ausführungsform der erfindungsgemäßen, integrierten dynamischen Speicherzelle 1, die entsprechend dem oben beschriebenen Herstellungsverfahren hergestellt ist. Bei der in Fig. 5 gezeigten Struktur liegen die beiden MOSFETS 2, 3 der Speicherzelle 1 in dem Graben 21 gegenüber. Entsprechend dem in Fig. 8 dargestellten Schaltkreisdiagramm bildet der in Fig. 5 auf der linken Seite gelegene MOSFET den Speicher-MOSFET 3 und der auf der rechten Seite gelegene MOSFET den Auswahl-MOSFET 2. Das Gate 8 des Auswahltransistors 2 wird durch den Spacer 33 gebildet, und das Gate 15 des Speichertransistors 3 wird durch den Spacer 32 gebildet. Die n-dotierte Schicht 25 stellt den Drainanschluss des Speicher-MOSFETs 3 dar und wird mit der Versorgungsspannung V_{DD} des Speichers verbunden. Der n-dotierte Bereich 26 bildet den Sourceanschluss-Bereich des Auswahltransistors 2, wobei der Metallkontakt 39 den Bitleitungsanschluss 5 bildet. Der Drain-Dotierungsbereich des rechts gelegenen Auswahltransistors 2 und der Source-Dotierungsbereich des links gelegenen Speichertransistors 3 sind über das Verbindungs-Dotierungsgebiet 27 am Boden des Ätzgrabens 21 miteinander verbunden. Das Dotierungsgebiet 27 am Boden des geätzten Grabens 21 bildet die leitende Verbindung 12 zwischen dem Drainanschluss 11 des Auswahltransistors 2 und dem Sourceanschluss 13 des Speichertransistors 3.

Das diodenähnliche Bauelement 16 in Fig. 8 wird durch die dünne dielektrische Schicht 35 gebildet. Die dünne dielektrische Schicht 35 besteht dabei aus einem Oxid, Nitrid oder einem Oxynitrid. Der Auswahl-MOSFET 2 auf der rechten Seite des geätzten Grabens 21 weist einen Gateanschluss-Bereich auf, der mit einer Wortleitung WL verbunden ist. Der Auswahl-MOSFET 2 besitzt ferner einen Sourceanschluss-Dotierungs-bereich 26, der über den Metallkontakt 39 mit einer Bitleitung BL verbunden ist.

Der Speicher-MOSFET 3 besitzt einen Gateanschluss-Bereich 32, der über die dünne dielektrische Schicht 35 an das Verbindungs-Dotierungsgebiet 27 angeschlossen ist. Das Verbindungs-Dotierungsgebiet 27 verbindet einen Sourceanschluss-Dotierungsbereich des Speicher-MOSFETs 3 auf der linken Seite des geätzten Grabens 21 mit dem Drainanschluss-Dotierungsbereich des Auswahl-MOSFETs 2 auf der rechten Seite des geätzten Grabens 21. Der Drainanschluss-Dotierungsbereich 14 des Speicher-MOSFETs 3 wird mit der Versorgungsspannung V_{DD} des Speichers versorgt. Der Auswahl-MOSFET 2 und der Speicher-MOSFET 3 sind in dem in das Halbleitersubstrat geätzten Graben 21 an den Seitenwänden 28, 29 derart angeordnet, dass sie einander gegenüberliegen, wobei das Verbindungs-Dotierungsgebiet 27 den Boden des geätzten Grabens 21 bildet.

Die in Fig. 5 gezeigte Ausführungsform zeigt zwei NMOS-MOSFETS. Bei einer alternativen Ausführungsform können jedoch auch PMOS-MOSFETS durch das erfindungsgemäße Herstellungsverfahren hergestellt werden.

Die dünne dielektrische Schicht 35 ist derart dünn ausgebildet, dass durch sie Tunnelströme zwischen dem Gateanschluss-Bereich 32 des Speicher-MOSFETs 3 und dem Verbindungs-Dotierungsgebiet 27 fließen können. Dabei können die durch die dünne dielektrische Schicht 35 fließenden Tunnelströme durch die Dotierung des n-Polysiliziumbereichs 37 und durch die Dotierung des Verbindungs-Dotierungsgebietes 27 eingestellt werden. Die dünne dielektrische Schicht weist dabei vorzugsweise eine Dicke von unter 2 nm auf.

Der geätzte Graben 21 kann prinzipiell beliebig tief geätzt werden. Die Breite des geätzten Grabens 21 entspricht vorzugsweise der minimalen lithographischen Strukturgröße F. Da die Länge der dotierten stromleitenden Kanäle, die parallel zu den Seitenwänden 28, 29 des geätzten Grabens 21 verlaufen, durch die Ätztiefe des Grabens 21 festgelegt werden können, können Leckströme, die aus der Speicherzelle 1 über den Auswahltransistor 2 über den Bitleitungsanschluss 5 fließen werden, indem man die Länge der dotierten Stromleitkanäle erhöht.

Die Gateanschluss-Bereiche 33 des auf der rechten Seite liegenden Auswahl-MOSFETs 2, die das Gate 8 bilden, verlaufen durchgängig durch den geätzten Graben 21. Der Gateanschluss-bereich des Auswahl-MOSFETs 2 der dynamischen Speicherzelle 1 wird durch einen in dem geätzten Graben 21 durchgängig verlaufenden Spacer 33 aus n-Polysilizium gebildet, der gleichzeitig die Gateanschluss-Bereiche für eine Vielzahl von weiteren Auswahl-MOSFETS für weitere dynamische Speicherzellen 1 bildet.

Da die Breite des geätzten Grabens 21 etwa der minimalen lithographischen Strukturgröße F entspricht und der Abstand zwischen den Isoliergräben in dem Halbleitersubstrat ebenfalls etwa dem Abstand einer minimalen lithographischen Strukturgröße F entspricht, weist die erfindungsgemäße Speicherzelle 1 etwa eine Seitenlänge auf, die zweimal so groß ist wie die minimale lithographische Strukturgröße F. Dementsprechend ist die Ausbreitungsfläche der erfindungsgemäßen dynamischen Speicherzelle 1 in etwa das Vierfache der quadratischen lithographischen Strukturgröße 4F².

Das erfindungsgemäße Herstellungsverfahren für die dynamische Speicherzelle kann variiert werden. Beispielsweise kann man, um eventuelle Leckströme an den PN-Übergängen an dem Grabenboden zu minimieren, statt einer n-Ionenimplantation in den Grabenboden auch die Dotierung aus einer Phosphor- oder Arsenglasschicht am Grabenboden austreiben.

Bei einer weiteren Ausführungsform der erfindungsgemäßen Speicherzelle wird die n-Polysiliziumschicht 24 zum Anschluss an die Versorgungsspannung sehr dick ausgeführt, um eine größere Überlappkapazität zwischen dem Versorgungsspannungsanschluss und dem Gateanschluss-Bereich 32 des Speicher-MOSFETs 3 zu ermöglichen.

Bei einer alternativen Ausführungsform des erfindungsgemäßen Herstellungsverfahrens kann man den Prozess nach der Strukturierung der aus Polysilizium bestehenden Spacer 32, 33 und der isolierenden Oxidschicht am Grabenboden umstellen. Hierbei wird zunächst ein dünner Spacer aus Siliziumdioxid über die aus Polysilizium bestehenden Spacer 32a, 33a gelegt. Anschließend wird die dünne dielektrische Schicht 35 thermisch am Grabenboden aufgewachsen und durch Abscheiden und Rückätzen ein darüberliegender Polysilizium-Plug 37 erzeugt. Die derart gebildete Struktur ist in Fig. 6 zu sehen.

Danach wird die Struktur mit Siliziumdioxid aufgefüllt. Anschließend erfolgt eine trockene Strukturierung nach einem Photoprozess durch Ätzung, bei der nur der Speicher-MOSFET 3 freiliegend verbleibt. Die Trockenätzung beseitigt dabei auch die aus Siliziumdioxid gebildeten Spacer. Ein danach abgeschiedener und strukturierter n-Polysilizium-Spacer verbindet dann den Polysilizium-Plug mit dem Gateanschluss-Bereich des Speicher-MOSFETs, wie man aus Fig. 7 erkennen kann.

Die Gateanschluss-Spacer des Speicher-MOSFETs 3 und der Plug werden dann mittels Ätzen derart strukturiert, dass sie nur an den aus Siliziumhalbleitersubstrat gebildeten Grabenwänden stehenbleiben, aber an den aus isolierendem Oxid bestehenden Grabenwänden entfernt werden. Die ganze Struktur wird dann wiederum mit einer Zwischenoxidschicht bedeckt und eine Metallisierung vorgenommen.

### Bezugszeichenliste

- 1: Speicherzelle
- 2: Auswahl-MOSFET
- 3: Speicher-MOSFET
- 4: Wortleitungsanschluss
- 5: Bitleitungsanschluss
- 6: Versorgungsspannungsanschluss
- 7: Leitung
- 8: Gateanschluss
- 9: Sourceanschluss
- 10: Leitung
- 11: Drainanschluss
- 12: Leitung
- 13: Sourceanschluss
- 14: Drainanschluss
- 15: Gateanschluss
- 16: diodenähnliches Bauelement
- 17: Leitung
- 18: -
- 19: -
- 20: Nitrid-Hartmaskenschicht
- 21: Ätzgraben
- 22: Halbleitersubstratsteg
- 23: Halbleitersubstratsteg
- 24: Polysiliziumschicht
- 25: Implantationsschicht
- 26: Implantationsschicht
- 27: Verbindungs-Dotierungsgebiet
- 28: Seitenwand des Ätzgrabens
- 29: Seitenwand des Ätzgrabens
- 30: Isolierschicht
- 31: Isolierschicht
- 32: Spacer
- 33: Spacer
- 34: Isoliermaterial
- 35: dünne dielektrische Schicht
- 36: dielektrische Abscheidungsschicht
- 37: Polysiliziumschicht
- 38: Polysiliziumschicht
- 39: Metallkontakt

## Patentansprüche

1. Integrierte dynamische Speicherzelle (1) mit geringer Ausbreitungsfläche auf einem Halbleitersubstrat, die aufweist:
(a) einen Auswahl-MOSFET (2) mit einem Gateanschluss-Bereich (8, 33), der mit einer Wortleitung WL verbunden ist, einem Sourceanschluss-Dotierungsbereich (9, 26), der mit einer Bitleitung BL verbunden ist, und mit einem Drainanschluss-Dotierungsbereich (11, 27) ; und
(b) einen Speicher-MOSFET (3) mit einem Gateanschluss-Bereich (15, 32), der über eine dünne dielektrische Schicht (35) an ein Verbindungs-Dotierungsgebiet (12, 27) angeschlossen ist, welches einen Sourceanschluss-Dotierungsbereich (13) des Speicher-MOSFETs (3) mit dem Drainanschluss-Dotierungsbereich (11) des Auswahl-MOSFETs (2) verbindet, und mit einem Drainanschluss-Dotierungsbereich (14, 24), der an eine Versorgungsspannung VDD anliegt;
(c) wobei der Auswahl-MOSFET (2) und der Speicher-MOSFET (3) in einem in das Halbleitersubstrat geätzten Graben (21) an den Seitenwänden (28, 29) des Grabens (21) derart angeordnet sind, dass sie einander gegenüberliegen und das Verbindungs-Dotierungsgebiet (27) den Boden des geätzten Grabens (21) bildet,
**dadurch gekennzeichnet,**
dass die dünne dielektrische Schicht (35) eine Dicke von weniger als 2 nm aufweist, so dass Tunnelströme zwischen dem Gateanschluss-Bereich (32) des Speicher-MOSFETs (3) und dem Verbindungs-Dotierungsgebiet (27) fließen, und dass die durch die dünne dielektrische Schicht (35) fließenden Tunnelströme durch die Dotierung eines aus n-Polysilizium gebildeten Anschlussbereichs (37) und durch die Dotierung des Verbindungs-Dotierungsgebietes (27) einstellbar sind.

2. Speicherzelle nach Anspruch 1
**dadurch gekennzeichnet,**
dass der Auswahl-MOSFET (2) und der Speicher-MOSFET (3) NMOS-Transistoren sind.

3. Speicherzelle nach Anspruch 1 oder 2,
**dadurch gekennzeichnet,**
dass die dünne dielektrische Schicht (35) eine asymmetrische Stromdurchlasskennlinie aufweist.

4. Speicherzelle nach einem der vorangehenden Ansprüche,
**dadurch gekennzeichnet,**
dass die dünne dielektrische Schicht (35) aus Oxid, Nitrid oder einem Oxynitrid besteht.

5. Speicherzelle nach einem der vorangehenden Ansprüche,
**dadurch gekennzeichnet,**
dass der Auswahl-MOSFET (2) und der Speicher-MOSFET (3) jeweils eine Gate-oxidschicht aufweisen, die entlang den Seitenwänden (28, 29) des geätzten Grabens (21) verläuft.

6. Speicherzelle nach einem der vorangehenden Ansprüche,
**dadurch gekennzeichnet,**
dass die Gateanschluss-Bereiche (32, 33) des Auswahl-MOSFETs (2) und des Speicher-MOSFETs (3) durch Spacer gebildet werden.

7. Speicherzelle nach einem der vorangehenden Ansprüche,
**dadurch gekennzeichnet,**
dass die Sourceanschluss-Bereiche und die Drainanschluss-Bereiche und das Verbindungs-Dotierungsgebiet durch Ionenimplantation hergestellt sind.

8. Speicherzelle nach einem der vorangehenden Ansprüche,
**dadurch gekennzeichnet,**
dass neben den Gateoxidschichten des Auswahl-MOSFETs (2) und des Speicher-MOSFETs (3) jeweils dotierte Stromleitkanäle liegen, deren Dotierung zur Festlegung der jeweiligen Einsatzspannung der MOSFETs (2, 3) einstellbar ist.

9. Speicherzelle nach einem der vorangehenden Ansprüche,
**dadurch gekennzeichnet,**
dass die dotierten Stromleitkanäle durch Ionenimplanatation hergestellt sind.

10. Speicherzelle nach einem der vorangehenden Ansprüche,
dadurch gekennzeichnet,
dass die Breite des geätzten Grabens (21) der minimalen lithographischen Struktur F entspricht.

11. Speicherzelle nach einem der vorangehenden Ansprüche,
**dadurch gekennzeichnet,**
dass die Länge der dotierten Stromleitkanäle im wesentlichen der Tiefe des geätzten Grabens (21) entspricht.

12. Speicherzelle nach einem der vorangehenden Ansprüche,
**dadurch gekennzeichnet,**
dass die Tiefe des geätzten Grabens (21) größer ist als dessen Breite.

13. Speicherzelle nach einem der vorangehenden Ansprüche,
**dadurch gekennzeichnet,**
dass der Gateanschluss-Bereich (33) des Auswahl-MOSFETs (2) einer dynamischen Speicherzelle (1) durch einen im geätzten Graben durchgängig verlaufenden Spacer (33) gebildet wird, der die Gateanschluss-Bereiche für eine Vielzahl von weiteren Auswahl-MOSFETs von weiteren dynamischen Speicherzellen bildet.

14. Speicherzelle nach einem der vorangehenden Ansprüche,
**dadurch gekennzeichnet,**
dass die Ausbreitungsfläche der dynamischen Speicherzelle (1) etwa das Vierfache der quadratischen kleinsten lithographischen Strukturgröße F² beträgt.

15. Speicherzelle nach einem der vorangehenden Ansprüche,
**dadurch gekennzeichnet,**
dass die Halbleitersubstratbereiche von Auswahl-MOSFETs (2) verschiedener Speicherzellen, die auf einer Seitenwand (29) des geätzten Grabens (21) angeordnet sind, durch Isolierschichten voneinander getrennt sind.

16. Speicherzelle nach einem der vorangehenden Ansprüche,
**dadurch gekennzeichnet,**
dass die Halbleitersubstratbereiche von Speicher-MOSFETs (3), die auf einer gegenüberliegenden Seite (28) des geätzten Grabens (21) angeordnet sind, durch Isolierschichten voneiannder getrennt sind.

17. Verfahren zur Herstellung einer integrierten dynamischen Speicherzelle, umfassend die folgenden Schritte:
(a) Implantieren der Oberfläche eines Halbleitersubstrats;
(b) Ätzen eines Grabens (21) in das Halbleitersubstrat;
(c) Implantieren des Halbleitersubstrats am Boden des geätzten Grabens (21) zur Bildung eines Drainanschluss-Dotierungsbereichs (27) und eines Verbindungs-Dotierungsgebietes (27);
(d) thermisches Oxidieren der beiden Seitenwände (28, 29) des geätzten Grabens (21) zur Ausbildung von dielektrischen Schichten an den Seitenwänden als Gateisolierschichten für einen Auswahl-MOSFET (2) und einen Speicher-MOSFET (3);
(e) Abscheiden einer isolierenden Oxidschicht auf dem Boden des geätzten Grabens;
(f) Ausbilden von Polysilizium-Spacern (32, 33) an den Seitenwänden (28, 29) des geätzten Grabens (21) als Gate-Elektroden für den Auswahl-MOSFET (2) und den Speicher-MOSFET (3);
(g) Ätzen der isolierenden Oxidschicht mit den gebildeten Polysilizium-Spacern (32, 33) als Maskierung, wobei ein mittlerer Oberflächenbereich des implantierten Substrats beigelegt wird;
(h) Füllen einer rechten oder linken Hälfte des geätzten Grabens (21) mit einem isolierenden Material (34);
(i) Abscheiden einer von Tunnelströmen durchdringbaren dünnen dielektrischen Schicht (35) auf der verbliebenen freiliegenden Hälfte des mittleren Oberflächenbereichs des Halbleitersubstrats am Boden des geätzten Grabens; und
(j) Abscheiden einer Polysiliziumschicht (37, 38) auf der dünnen dielektrischen Schicht (35).
